(19) Europäisches Patentamt / European Patent Office / Office européen des brevets

(11) **EP 4 145 505 A1**

(12) **DEMANDE DE BREVET EUROPEEN**

(43) Date de publication:
**08.03.2023  Bulletin 2023/10**

(21) Numéro de dépôt: **22192146.3**

(22) Date de dépôt: **25.08.2022**

(51) Classification Internationale des Brevets (IPC):
*H01L 25/07* (2006.01)      *H01F 17/06* (2006.01)
*H01L 23/64* (2006.01)      *H02M 1/12* (2006.01)
*H02M 1/00* (2006.01)      *H02M 7/00* (2006.01)
*H02M 7/06* (2006.01)      *H02M 7/5387* (2006.01)
*H01L 23/00* (2006.01)      *H01L 23/36* (2006.01)
*H01L 23/367* (2006.01)      *H01L 23/552* (2006.01)
*H03H 1/00* (2006.01)

(52) Classification Coopérative des Brevets (CPC):
(C-Sets disponibles)
**H01L 25/072; H01F 17/06; H01L 23/645;
H02M 1/007; H02M 1/123; H02M 7/003;
H02M 7/06; H02M 7/5387;** H01L 23/36;
H01L 23/367; H01L 23/552; H01L 24/45;
H01L 24/48; H01L 2224/451; H01L 2224/48091;

(Cont.)

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **26.08.2021  FR 2108957**

(71) Demandeur: **THALES
92400 Courbevoie (FR)**

(72) Inventeurs:
• **DUBOIS, Eric Ravindranath
78400 CHATOU (FR)**
• **KHERBOUCHI, Hocine
78400 CHATOU (FR)**
• **BERGER, Jean-Paul
78400 CHATOU (FR)**

(74) Mandataire: **Atout PI Laplace
Immeuble "Visium"
22, avenue Aristide Briand
94117 Arcueil Cedex (FR)**

(54) **COMPOSANT DE PUISSANCE A FILTRAGE LOCAL**

(57)     L'invention concerne un composant de commutation configuré pour commuter un signal électrique, le composant de commutation (30) comprenant :
- un substrat (34a,34b) portant plusieurs composants élémentaires (32a, 32b) assurant chacun la commutation du signal électrique,
- une semelle (46) sur laquelle est fixé le substrat (34a,34b), la semelle (46) étant configurée pour évacuer de la chaleur émise lors de commutations du composant de commutation,
- deux conducteurs électriques (40a, 42a ; 40b, 42b) connectés à chacun un des composants élémentaires (32a, 32b) et assurant respectivement l'entrée et la sortie du composant élémentaire (32a, 32b) concerné pour le signal ($I_C$) à commuter,
- un noyau magnétique (62a, 62b) réalisé en matériau ferromagnétique, le noyau magnétique (62a, 62b) entourant le composant élémentaire concerné (32a, 32b) sans entourer d'autres des composants élémentaires (32a, 32b) et étant disposé dans le composant (60) de façon à ce qu'un courant de déplacement entre le composant élémentaire (32a, 32b) entouré et la semelle (46) induise une induction magnétique dans le noyau magnétique (62a, 62b), et de façon à ce que le chemin suivi par un courant de conduction du signal électrique commuté par le composant (60) ne forme pas de spire autour du noyau magnétique (62a, 62b).

**Fig. 4**

(52) Classification Coopérative des Brevets (CPC):
(Cont.)
H01L 2224/48227; H01L 2224/48472;
H03H 2001/0057

C-Sets
H01L 2224/451, H01L 2924/00014;
H01L 2224/48091, H01L 2924/00014

**Description**

En électronique de puissance, de nombreux convertisseurs statiques ont été développés, principalement des onduleurs et des redresseurs. On trouve également des équipements plus complexes tels que des alimentations à découpage. Ces convertisseurs sont équipés de composants électroniques permettant commuter un signal électrique. Les composants de commutation sont souvent appelés : « interrupteurs électroniques ». Parmi ces composants, on peut citer les diodes, les transistors, les thyristors, les triacs...

Les diodes de puissance ont été développées à partir des années 1950. Dans les années 1960, les thyristors et les transistors de puissance apparaissent. Plus tard, dans les années 1980, apparaissent des transistors bipolaires à grille isolée connu par son acronyme anglais IGBT pour « Insulated Gate Bipolar Transistor ». Ce type de transistor combine l'avantage d'une commande au moyen d'un transistor à effet de champ et les faibles pertes par conduction d'un transistor bipolaire. A ce jour, les IGBT permettent de commuter des puissances de l'ordre de 10MW à des vitesses supérieures à 10kHz. Pour de plus faibles puissances, des transistors de type MOSFET sont également largement employés. Dans les années 2000, des composants, et notamment des transistors MOSFET, à base de carbure de silicium (SiC) apparaissent. Ils permettent d'atteindre des vitesses supérieures à 1 MHz. Plus récemment le nitrure de gallium GaN a également été introduit dans les transistors MOSFET pour réaliser des interrupteurs électroniques. Le nitrure de gallium permet de monter encore en vitesse de commutation à des fréquences supérieures à 10MHz.

En commutant des signaux électriques de puissance, ces composants génèrent des pertes thermiques qu'il est nécessaire d'évacuer. Le refroidissement des interrupteurs électroniques est le plus souvent réalisé au moyen de radiateurs permettant d'évacuer la chaleur par convection d'air circulant le long des parois du radiateur. Les radiateurs peuvent aussi être équipés de canaux dans lesquels circule un fluide réfrigérant.

Pour assurer un bon transfert thermique du composant vers son radiateur, il est nécessaire de réduire au maximum la résistance thermique du chemin parcouru par la chaleur depuis sa zone d'émission au cœur du composant jusqu'au radiateur permettant la dissipation de cette chaleur. L'interrupteur électronique dispose le plus souvent d'une semelle métallique disposée à proximité immédiate du cœur du composant et par laquelle transite la chaleur à évacuer. La semelle peut être isolée électriquement du composant ou former l'un de ses points de connexion. Lors du montage de l'interrupteur électronique, la semelle est plaquée contre le radiateur. Le contact de la semelle sur le radiateur peut être thermiquement amélioré au moyen d'une pâte thermiquement conductrice. Il est également possible d'interposer un isolant électrique entre la semelle et le radiateur sous forme de plaquette à base d'oxyde d'aluminium, de mica ou de silicone.

La sécurité des utilisateurs d'équipements mettant en œuvre des interrupteurs électroniques nécessite généralement une mise à la masse électrique des radiateurs. Pour une meilleure dissipation de la chaleur, il est même possible d'utiliser le boîtier extérieur de l'équipement comme radiateur. Ceci impose d'autant plus de raccorder le boîtier à la masse électrique du système comprenant l'équipement.

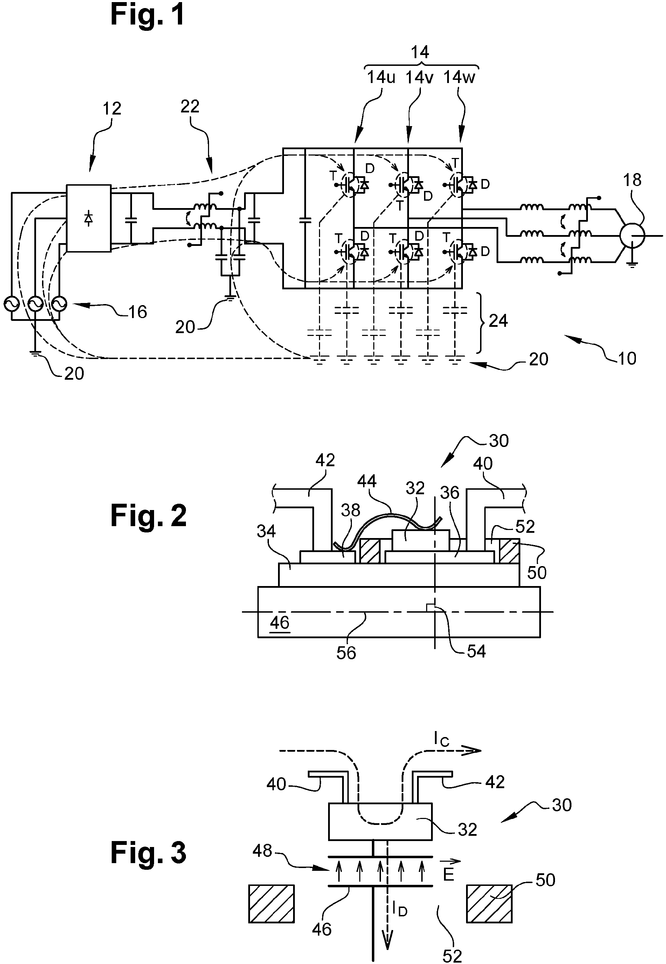

La figure 1 représente une architecture électrique 10 comprenant deux convertisseurs statiques : un redresseur 12 et un onduleur 14. L'architecture électrique 10 est bien adaptée à équiper un véhicule, notamment un aéronef. L'architecture électrique 10 comprend un réseau alternatif 16 permettant d'alimenter une charge 18, tel que par exemple un moteur au travers du redresseur 12, générant une tension continue à partir la tension alternative issue du réseau alternatif 16, et au travers de l'onduleur 14 fournissant une tension alternative à la charge 18 à partir de la tension continue.

Sur la figure 1, l'architecture électrique 10 est représentée de façon sommaire. En pratique, la tension continue peut former un réseau permettant d'alimenter un grand nombre de charges, chacune pouvant fonctionner avec une tension alternative différente. Il est possible d'adapter la fréquence de la tension alternative au besoin de la charge. On peut par exemple moduler la vitesse du moteur en faisant varier la fréquence au moyen de l'onduleur 14. Plusieurs onduleurs peuvent alimenter une même charge. L'architecture électrique 10 peut être reconfigurable en temps réel. Elle permet d'alimenter une charge au moyen d'autant de convertisseurs que nécessaire comme par exemple décrit dans la demande de brevet publiée sous le n° EP 2 887 519 A2 et déposée au nom de la demanderesse.

Des perturbations de mode commun peuvent circuler dans l'architecture électrique 10. Ces perturbations représentées en pointillés épais sur la figure 1 circulent principalement au travers d'une masse électrique 20 de l'architecture électrique 10. Le réseau alternatif 16 étant relié à la masse 20, les perturbations se superposent aux tensions alternatives du réseau alternatif 16 puis aux tensions continues issues du redresseur 12.

Les perturbations de mode commun peuvent être limitées au moyen de filtres inductifs disposés par exemple sur le réseau continu. Comme illustré sur la figure 1, un filtre de mode commun 22 comprend deux inductances disposées sur un même noyau magnétique. Dans chacune des inductances circule une phase du réseau continu. Les inductances sont réalisées au moyen de conducteurs électriques enroulés sur le noyau magnétique commun. Les conducteurs électriques formant les inductances sont dimensionnés pour supporter le courant utile du réseau continu. De ce fait, les sections de conducteurs sont importantes. Le noyau magnétique sur lequel les conducteurs sont enroulés est également volumineux. Ceci entraine un poids et un volume important pour le filtre 22.

Par ailleurs, les interrupteurs électroniques des convertisseurs possèdent une capacité parasite 24 formée entre le canal de conduction de l'interrupteur, la semelle et le radiateur. Cette capacité 24 est due à la proximité entre le canal de conduction, la semelle et le radiateur, proximité rendue nécessaire pour l'évacuation de la chaleur dégagée lors des commutations.

Des expérimentations en internes ont montré que les perturbations de mode commun tendent à se propager au travers des capacités parasites 24 des interrupteurs électroniques pour atteindre la masse électrique 20. Sur la figure 1, seules les capacités parasites 24 des interrupteurs électroniques de l'onduleur 14 sont représentées. Les diodes du redresseur 12 peuvent posséder également le même type de capacité parasite, dès qu'une de leurs électrodes est disposée à proximité ou en contact avec une pièce mécanique reliée électriquement à la masse électrique 20. Les courants formant les perturbations de mode commun sont d'autant plus importants que la fréquence de commutation augmente. Avec la mise en œuvre d'interrupteurs électroniques pouvant atteindre des temps de commutation extrêmement réduits, les courants de perturbation deviennent de plus en plus préoccupants. Du fait de leur volume et de leur masse, les solutions actuelles permettant de réduire les perturbations, notamment les courants de mode commun, sont difficiles à mettre en œuvre avec les nouvelles générations d'interrupteurs électroniques.

Il existe des boîtiers de commutation comprenant différents types de composants élémentaires de commutation, comme par exemple un boîtier onduleur comprenant plusieurs transistors chacun associé à une diode de roue libre. Il est possible de limiter les perturbations de ce boîtier au moyen d'un noyau magnétique entourant l'ensemble du boîtier. La demanderesse s'est rendue compte que cette disposition du noyau magnétique manque d'adaptation à chacun des composants élémentaires. De plus, en cas de défaillance d'un des composants élémentaires entrainant une surintensité le traversant, le noyau magnétique peut saturer et ne plus remplir sa fonction vis-à-vis des autres composants élémentaires. Pour limiter le risque de saturation, il est possible d'augmenter les dimensions du noyau magnétique. Cependant cette augmentation de dimensions tend à augmenter l'encombrement, la masse et le coût du noyau magnétique.

L'invention propose une solution à ces problèmes en filtrant à la source les courants pouvant transiter dans les capacités parasites des interrupteurs électroniques. Le filtrage proposé par l'invention se fait au plus près de chaque composant élémentaire.

A cet effet, l'invention a pour objet un composant de commutation configuré pour commuter un signal électrique, le composant de commutation comprenant :

- un substrat portant plusieurs composants élémentaires assurant chacun la commutation du signal électrique,

- une semelle sur laquelle est fixé le substrat, la semelle étant configurée pour évacuer de la chaleur émise lors de commutations du composant de commutation,

- deux conducteurs électriques connectés à chacun un des composants élémentaires et assurant respectivement l'entrée et la sortie du composant élémentaire concerné pour le signal à commuter,

- un noyau magnétique réalisé en matériau ferromagnétique, le noyau magnétique entourant le composant élémentaire concerné sans entourer d'autres des composants élémentaires et étant disposé dans le composant de façon à ce qu'un courant de déplacement entre le composant élémentaire entouré et la semelle induise une induction magnétique dans le noyau magnétique, et de façon à ce que le chemin suivi par un courant de conduction du signal électrique commuté par le composant ne forme pas de spire autour du noyau magnétique.

En entourant au moyen d'un noyau magnétique, le composant élémentaire concerné, et éventuellement plusieurs composants élémentaires au moyen de plusieurs noyaux indépendants les uns des autres, le filtrage peut être adapté au mieux au composant élémentaire concerné. Il est possible de réaliser le noyau magnétique en entourant le composant concerné au plus près. On réduit ainsi la longueur magnétique du noyau magnétique, ce qui permet d'en améliorer l'efficacité. Lorsque le composant comprend plusieurs composants élémentaires, il est possible de choisir, parmi les composant élémentaires, celui ou ceux entourés par un noyau magnétique. Lorsque plusieurs noyaux magnétiques sont présents, chacun associé à un composant élémentaire l'indépendance des différents noyaux magnétiques permet tout d'abord d'en déterminer les caractéristiques de façon indépendante : choix du matériau ferromagnétique et dimensionnement.

Avantageusement, le noyau magnétique est réalisé en matériau ferromagnétique possédant une partie imaginaire de perméabilité magnétique relative supérieure à 10.

Avantageusement, le noyau magnétique est réalisé en matériau ferromagnétique nanocristallin.

Le noyau magnétique peut comprendre un évidement central entourant le composant élémentaire.

Le noyau magnétique peut être fermé, c'est-à-dire sans entrefer ou ouvert, c'est-à-dire avec au moins un entrefer.

Alternativement à la présence d'un évidement central, le noyau magnétique peut être en forme de plaque disposée sous le substrat.

L'invention sera mieux comprise et d'autres avantages apparaîtront à la lecture de la description détaillée d'un mode de réalisation donné à titre d'exemple, description illustrée par le dessin joint dans lequel :

la figure 1, déjà décrite, représente une architecture électrique dans laquelle l'invention peut être mise en œuvre ;

la figure 2 représente un premier exemple de mise en place d'un noyau magnétique à l'intérieur d'un composant de commutation ;

la figure 3 représente schématiquement la circulation de courants dans le composant représenté sur la figure 2 ;

la figure 4 représente un composant de commutation comprenant plusieurs composants élémentaires ;

La figure 5 représente une variante du composant de commutation de la figure 4.

Par souci de clarté, les mêmes éléments porteront les mêmes repères dans les différentes figures.

La figure 2 représente en coupe un composant de commutation 30 comprenant un composant élémentaire 32 à base de semi-conducteur. Tout type de composant élémentaire peut être mis en œuvre dans le cadre de l'invention. Le composant élémentaire peut être à commutation naturelle comme une diode ou à commutation commandée tel qu'un thyristor ou un transistor. A ce jour, de nombreux matériaux sont mis en œuvre pour réaliser des composants élémentaires de commutation, notamment le silicium, le germanium, l'arséniure de gallium, le carbure de silicium, le nitrure de gallium. L'invention peut être mise en œuvre quel que soit le matériau semi-conducteur mis en œuvre.

La figure 2 représente schématiquement en coupe le composant 30. Le composant élémentaire 32 sous forme d'une puce est déposé sur un substrat 34 isolant, par exemple en céramique. Une métallisation recouvre sélectivement le substrat 34 et permet de raccorder électriquement le composant élémentaire 32. La métallisation comprend ici deux parties 36 et 38. La partie 36 reçoit une broche 40 et la partie 38, une broche 42. La partie 36 s'étend sous le composant élémentaire 32 et forme une première électrode du composant 30. La partie 38 est raccordée électriquement à la partie supérieure du composant élémentaire 32 au moyen d'une ou plusieurs jambes métalliques 44 formant une seconde électrode du composant 30. Un signal électrique peut circuler entre les deux broches 40 et 42 en fonction de l'état de la jonction dans le semi-conducteur formant le composant élémentaire 32. Pour un composant à commutation naturelle, la différence de potentiel entre les deux broches 40 et 42 détermine l'état de la jonction et pour un composant à commutation commandée, une électrode de commande, non représentée sur la figure 2, permet le déclenchement de la commutation en faisant passer la jonction d'un état bloqué à un état passant. L'électrode de commande peut être reliée à une autre partie de la métallisation au moyen d'une autre jambe non située dans le plan de coupe de la figure 2.

Lors de son fonctionnement, le composant 30 dégage de la chaleur formant des pertes qu'il convient d'évacuer. Cette chaleur est principalement dégagée lors des commutations et lorsque la jonction est passante du fait de sa résistance interne. La chaleur générée dans le composant élémentaire 32 est principalement drainée vers une semelle 46 sur laquelle le substrat 34 est fixé. La semelle 46 est par exemple réalisée en alliage métallique pour sa bonne capacité à conduire la chaleur. La semelle 46 peut par exemple être réalisée en alliage de cuivre ou d'aluminium. La semelle 46 peut être fixée à un radiateur, non représenté sur la figure 1 et permettant l'évacuation de la chaleur. L'évacuation peut se faire dans l'air ambiant par convection naturelle ou forcée. L'évacuation peut également se faire au moyen d'un de canaux circulant dans le radiateur et dans lesquels circule un fluide caloporteur. Le dimensionnement du radiateur est réalisé en fonction de la chaleur générée par le composant 30 lors de son utilisation et, pour une évacuation par convection, en fonction du milieu ambiant dans lequel baigne le radiateur. Il est courant de raccorder le radiateur à la masse électrique de l'équipement dans lequel le composant 30 et mis en œuvre, par exemple un convertisseur 12 ou 14 tels que représentés sur la figure 1.

Comme évoqué plus haut, une capacité parasite se forme entre, d'une part le composant élémentaire 32 et ou la partie 36 de la métallisation, et d'autre part la semelle 34, le substrat 34 formant un diélectrique de cette capacité parasite. Une autre capacité parasite se forme dans le composant élémentaire 32 lui-même entre ses électrodes. Un courant de déplacement peut se former entre la jonction et la semelle 46 au travers de la capacité parasite. Ce courant peut être d'autant plus important que la vitesse de commutation augmente. En pratique, lors d'une commutation le courant circulant dans la jonction s'établit ou s'interrompt formant un échelon de courant dans un chronogramme. La demanderesse s'est aperçu que la répétition de ces échelons de courant génère des courants de fuite non négligeable circulant dans la masse électrique du système au travers de la capacité parasite du composant 30. L'invention cherche à limiter le courant circulant dans cette capacité parasite au moyen d'un noyau magnétique 50 entourant le composant élémentaire 32.

Le courant circulant dans la capacité parasite, appelé courant de déplacement, traverse l'évidement central 52 du noyau magnétique 50 qui forme ainsi une inductance tendant à s'opposer à l'établissement de ce courant. Pour éviter que le noyau magnétique ne soit soumis au signal utile commuté par le composant et circulant entre les deux broches 40 et 42, le noyau magnétique 50 est disposé dans le composant de façon à ce que le chemin suivi par le courant, appelé courant de conduction, du signal utile ne forme pas de spire autour du noyau magnétique 50. Plus précisément, le courant utile circule entre les deux broches 40 et 42 en passant par la partie 36 de la métallisation, la jonction du composant élémentaire 32, la jambe 44 et la partie 38 de la métallisation. Ce chemin peut en partie pénétrer dans l'évidement central 52 et en ressortir du même côté du noyau magnétique 50 sans former de spire enroulé autour du noyau magnétique 50. Une telle réalisation est bien adaptée à des composants 30 dans lesquels les broches 40 et 42 sont disposées d'un même côté de la semelle 46.

La figure 3 représente schématiquement la circulation de courants dans le composant représenté sur la figure 2. Le courant de conduction $I_C$ formant le signal électrique commuté circule entre les broches 40 et 42 par la jonction formée dans le composant élémentaire 32. La ou les capacités parasites formées dans le composant 30 ou à l'extérieur de celui-ci portent le repère 48. Dans ces capacités un champ électrique $\vec{E}$ apparait et sa variation temporelle induit un courant de déplacement $I_D$ qui se reboucle dans l'architecture électrique 10 intégrant le composant 30. En pratique, le courant de déplacement $I_D$ forme essentiellement les perturbations représentées en pointillés épais sur la figure 1. Le courant de déplacement $I_D$ se reboucle par une ou par les deux broches 40 et 42. Le courant de déplacement $I_D$ se superpose au courant utile commuté par le composant et appelé courant de conduction $I_C$. La valeur du courant de déplacement $I_D$ peut dépasser le pourcent de la valeur du courant de conduction $I_C$. Comme évoqué plus haut, plus la vitesse de commutation du composant est grande, plus la valeur du courant de déplacement $I_D$ augmente. En disposant le noyau magnétique 50 de façon à ce que le courant de déplacement $I_D$ traverse l'évidement central 52, le chemin suivi par le courant de déplacement $I_D$ forme une spire autour du noyau magnétique 50 du fait du rebouclage de ce courant. En pratique, le courant appelé courant de déplacement s'établit entre les armatures d'une capacité en l'absence de support sous forme de conducteur électrique. Au-delà des armatures, ce courant est conduit par différents conducteurs électriques et notamment la semelle 46. Il devrait donc être également qualifié de courant de conduction. Par simplicité, et pour le distinguer du courant utile commuté par le composant et appelé courant de conduction, le courant s'établissant au travers des capacités parasites 48 du composant 30 sera appelé par la suite courant de déplacement même lorsqu'il est porté par des conducteurs électriques en amont ou en aval des capacités parasites 48. Le noyau magnétique 50 peut être disposé précisément en entourant la ou les capacités parasites 48 du composant 30. Le noyau magnétique peut également être disposé en amont ou en aval de ces capacités parasites sur le chemin suivi par le courant de déplacement $I_D$ même lorsque celui-ci est porté par un conducteur électrique. Cela présente un intérêt, notamment lorsqu'il est impossible de déterminer avec précision où sont situées toutes les capacités parasites du composant 30. Il est cependant avantageux de disposer le noyau magnétique dans le composant 30, ou à proximité immédiate de celui-ci, comme on le verra plus loin afin de mieux maîtriser les conducteurs électriques susceptibles de porter le courant de déplacement. Ceci permet notamment de permettre au composant 30 de fixer sa semelle 46 sur tout type de support, notamment réalisés en matériaux conducteur de l'électricité et susceptible de voir transiter le courant de déplacement $I_D$ lors de son rebouclage.

Il est possible de mettre en œuvre un noyau magnétique 50 fermé sans entrefer. Ce type de noyau est appelé par de nombreux fabricant : « noyau torique ». Il est formé autour d'un évidement central. La qualification de torique pour le noyau magnétique va bien au-delà de la définition mathématique d'un tore. On trouve notamment des noyaux magnétiques dits toriques à section circulaire, rectangulaire... Pour équiper le composant 30, la forme de la section du noyau magnétique 50 est adaptée à la forme du composant élémentaire 32 et à celle de la partie 36 de la métallisation.

Alternativement, il est possible de mettre en œuvre un noyau magnétique ouvert, c'est-à-dire avec entrefer, autrement dit entourant partiellement le composant élémentaire 32. Un entrefer permet d'adapter les caractéristiques du noyau magnétique 50 au filtrage que l'on souhaite réaliser. Un entrefer permet notamment d'augmenter la valeur maximale d'un courant de déplacement traversant le noyau magnétique avant saturation du noyau magnétique. Dans la pratique, il est possible de prévoir un ou plusieurs entrefers dans la forme du noyau magnétique 50. En variante, l'entrefer ou les entrefers peuvent être partiels, par exemple réalisés sous forme d'encoches ou complets, c'est-à-dire coupant de part en part le noyau magnétique.

Afin de permettre l'effet optimum du noyau magnétique 50 sur le courant de déplacement $I_D$ pouvant circuler dans les capacités parasites du composant 30, le noyau magnétique 50 s'étend autour d'un axe 54 sensiblement perpendiculaire au plan 56 dans lequel s'étend la semelle 46. En effet, on peut considérer la semelle 46 comme une des armatures conductrices de la ou des capacités parasites du composant 30 et le courant de déplacement $I_D$ circule en grande partie perpendiculairement à cette armature. Dans la pratique, l'effet du noyau magnétique 50 sur le courant de déplacement $I_D$ apparait lorsque l'axe 54 n'est pas parallèle au plan de la semelle 46.

Le noyau magnétique 50 est réalisé en matériau ferromagnétique. Idéalement, on choisit un matériau à forte perméabilité relative. La perméabilité relative maximum, habituellement notée $\mu_r$, relie dans un domaine linéaire le champ magnétique B et le champ d'excitation magnétique H induit par le courant de déplacement. On considère généralement que les matériaux à forte perméabilité relative possèdent une valeur $\mu_r$ supérieure à 30 000. On peut réaliser la mesure de la perméabilité magnétique relative maximum pour une excitation magnétique de 100 mA/cm à une fréquence de 10k Hz. De nombreux fabricants de matériaux magnétiques affichent dans leur catalogue la valeur de perméabilité relative maximum avec une tolérance de +/- 15%. Ce type de mesure avec sa tolérance peut être pris en compte dans le cadre de l'invention.

Les noyaux magnétiques sont habituellement utilisés avec des spires de conducteurs électriques enroulés autour des noyaux magnétiques et dans lesquels circulent un courant électrique. Dans le cadre de l'invention, le noyau magnétique 50 est utilisé sans spire de conducteur électrique traversant l'évidement central 52. Cependant un champ électrique variable peut s'établir dans l'évidement central 52 ou dans son prolongement le long de l'axe 54. La quatrième équation de Maxwell, également appelée loi d'Ampère-Maxwell, prévoit que le rotationnel de l'induction magnétique H est proportionnel à la densité de courant $\vec{J}$ dans un conducteur et à la variation temporelle du champ électrique $\vec{E}$.

$$\vec{\nabla} \wedge \mu \vec{H} = \frac{1}{c}\left(4\pi\vec{J} + \frac{\partial\vec{E}}{\partial t}\right)$$

Dans l'invention, en l'absence de conducteur électrique traversant l'évidement central 52, le courant de conduction représentée par le vecteur $\vec{J}$, est nul. On ne s'intéresse qu'à la variation temporelle du champ électrique $\vec{E}$ dans les capacités parasites du composant 30. Cette variation temporelle génère un courant de déplacement $I_D$. D'après la troisième équation de Maxwell, également appelée loi de Faraday, la variation temporelle d'induction magnétique $\vec{H}$ dans le noyau magnétique 50 induit un champ électrique $\vec{E1}$ opposé au champ électrique $\vec{E}$ généré par le courant de déplacement $I_D$ circulant dans la capacité parasite.

$$\vec{\nabla} \wedge \vec{E1} = -\mu\,\frac{\partial\vec{H}}{\partial t}$$

Ce champ électrique opposé tend à s'opposer à l'établissement des courants de fuites par la capacité parasite. En première approche, cette opposition peut se modéliser par une inductance connectée en série de la capacité parasite du composant 30. La valeur de l'inductance est d'autant plus importante que la perméabilité relative maximum du noyau magnétique 50 est forte. En effet, dans les deux équations de Maxwell cité plus haut, apparait la perméabilité magnétique μ du milieu. Cette perméabilité est égale au produit de la perméabilité du vide $\mu_0$ par la perméabilité relative $\mu_r$ du milieu, voisine de 1 pour l'air et beaucoup plus importante pour un noyau magnétique en matériau ferromagnétique. Pour conserver une valeur d'inductance élevée, le noyau magnétique 50 doit rester dans son domaine linéaire et éviter de se saturer. En effet, lors de la saturation, la perméabilité relative décroit jusqu'à devenir égale à 1. Autrement dit, un noyau magnétique fortement saturé n'a pratiquement aucune influence sur le champ magnétique qu'il génère en fonction de l'induction qu'il reçoit. Pour limiter les risques de saturation du noyau magnétique 50, on évite tout conducteur électrique formant une spire autour du noyau magnétique 50 et notamment une spire pouvant être formée par le chemin suivi par le courant circulant entre les broches 40 et 42. Plus précisément, le composant élémentaire 32 peut être situé à l'intérieur de l'évidement central. Mais l'entrée et la sortie du courant dans le composant élémentaire 32 doit se faire par un même côté de l'évidement central 52, par exemple par le dessus comme représenté sur la figure 2.

Parmi les matériaux ferromagnétiques connus, pour réaliser le noyau magnétique 50, il est possible de mettre en œuvre des matériaux formés d'alliages contenant majoritairement de fer et de nickel. Ces matériaux sont apparus au début du XX$^{ième}$ siècle et sont notamment connus sous le nom de « Permalloy » et de « Mumétal ». Ces matériaux sont cristallins et pour atteindre de bonnes propriétés magnétiques, des traitements thermiques sont nécessaires, traitement tendant à augmenter les dimensions des grains cristallins. Cette augmentation de taille de grains tend à détériorer les propriétés mécaniques de ces alliages les rendant difficiles à mettre en forme.

Des matériaux amorphes ont ensuite été développés afin de faciliter la mise en œuvre des matériaux ferromagnétiques. Cependant, la présence d'éléments amorphisants, tel que le bore par exemple, tend à limiter l'induction à saturation. De plus, des pertes magnétiques importantes apparaissent lors d'utilisations à haute fréquence.

Vers la fin du XX$^{ième}$ siècle, une nouvelle famille de matériaux nanocristallins a été développée, notamment par la société Arcelor-Mittal Imphy et connue sous le nom « Finemet ». Différentes nuances sont produites sous l'appellation « Nanophy ». Elles possèdent notamment des compositions de type FeCuMSiB où M est un métal de transition. Une composition largement utilisée est du type : $Fe_{73.5}Cu_1Nb_3Si_xB_{22.5-x}$ et contiennent 13.5% ou 16.5% de silicium.

Dans cette famille, des cristaux de fer-silicium sont noyés dans une matrice résiduelle amorphe. Les cristaux ont des dimensions de l'ordre du nanomètre. Par rapport aux alliages fer-nickel, les matériaux nanocristallins présentent l'avantage d'avoir une induction à saturation beaucoup plus élevée, de l'ordre de 1,3T au lieu de 0,7T typiquement pour le Permalloy.

Plus récemment, d'autres matériaux nanocristallins de type FeMB ont également été développés. Ils contiennent généralement plus de 80% de fer, 7% de métal de transition et le complément en bore. Les matériaux de cette famille comprennent des nano cristaux de fer pur. Leur induction à saturation est comparable à celle de la famille Finemet.

Les matériaux nanocristallins permettent de bénéficier de certains avantages des matériaux amorphes, notamment leur homogénéité. Ceci est dû, pour les matériaux nanocristallins, à une structure composée de très petits cristaux orientés aléatoirement et répartis de manière homogène dans une matrice amorphe et donc sans joint de grains.

Les matériaux nanocristallins sont souvent réalisés sous forme de rubans que l'on enroule pour former des noyaux magnétique fermés souvent appelés noyaux toriques.

L'ensemble de ces matériaux et tout autre matériau ferromagnétique peut bien entendu être utilisé dans le cadre de l'invention pour réaliser le noyau magnétique 50. Le choix de matériau est réalisé en fonction des courants de déplacement susceptibles de circuler dans les capacités parasites du composant 30 et en fonction du risque de saturation du noyau magnétique 50.

Des essais en interne ont montré que des matériaux ferromagnétiques ayant une perméabilité magnétique maximum relative supérieure à 100 apportent un effet de réduction des courants de déplacement.

Les matériaux ferromagnétiques nanocristallins possèdent des valeurs de perméabilité magnétique relative bien plus élevées (typiquement supérieure à 30000) et sont d'autant plus efficaces.

Plus précisément, il est possible de définir une perméabilité magnétique relative complexe : $\mu_r = \mu_r' - j\mu_r''$. La partie réelle $\mu_r'$ de la perméabilité magnétique représente la faculté de stocker de l'énergie magnétique, c'est-à-dire la partie inductance de l'impédance apportée par le noyau magnétique. La partie imaginaire $\mu_r''$ de la perméabilité magnétique représente les pertes magnétiques et peut s'apparenter à une résistance dissipant de l'énergie sous forme de chaleur.

La plupart des fabricants de noyaux magnétiques donnent une valeur numérique de la perméabilité magnétique relative. Cette valeur numérique correspond au module de la perméabilité magnétique relative complexe. Pour un matériau donné, Il est possible de retrouver la partie réelle et la partie imaginaire en réalisant une mesure d'impédance d'un enroulement réalisé autour d'un noyau magnétique réalisé dans le matériau considéré. Plus précisément :

$$\mu_r' = (I \cdot L_{eff}) / (\mu_0 \cdot N^2 \cdot A)$$

$$\mu_r'' = (I \, (R_{eff} - R_\omega)) / (\mu_0 \cdot N^2 \cdot \omega \cdot A)$$

Dans ces deux formules : I représente la longueur magnétique moyenne du noyau utilisé pour réaliser la mesure d'impédance, $L_{eff}$ représente l'inductance mesurée, N représente le nombre de spires de l'enroulement utilisé pour la mesure d'impédance, A représente la surface de la section du noyau magnétique, $R_{eff}$ représente la résistance équivalente aux pertes magnétiques, incluant la résistance de l'enroulement seul, $R_\omega$ représente la résistance de l'enroulement seul, $\mu_0$ représente la perméabilité absolue du vide ($4\pi$ $10^{-7}$ H/m) et $\omega$ représente la pulsation ($2\pi f$) à laquelle la mesure d'impédance est réalisée. Comme pour les valeurs numériques données par les fabricants, on pourra choisir une pulsation correspondant à une fréquence de 10kHz. La société Keysight Technologies dont le siège social est située aux Etats Unis d'Amérique : 1400 Fountaingrove Parkway Santa Rosa, CA 95403-1738 propose une méthode précise de mesure dans un document : « Solution for Measuring Permittibity and Permeability with LCR Meters and Impedance Analysers » publié le 3 août 2014 et disponible à la date de dépôt de la présente demande de brevet à l'adresse :

https://www.keysight.com/fr/en/assets/7018-06683/application-notes/5980-2862.pdf

La mise en place d'un noyau magnétique selon l'invention permet d'atténuer la résonance des perturbations décrites à l'aide de la figure 1. Cette résonance est due à un circuit de type LC où la capacité est la capacité parasite du composant de commutation et où l'inductance est celle du circuit auquel appartient le composant de commutation. En ajoutant un noyau magnétique selon l'invention, la fréquence de résonance des perturbations est réduite et la partie complexe de la perméabilité magnétique permet d'atténuer le facteur de qualité du circuit résonant. Ces deux paramètres, réduction de la fréquence et du facteur de qualité permettent de réduire grandement les perturbations.

Bien que la partie imaginaire de la perméabilité magnétique, soit fonction de la fréquence de résonance du circuit dans son ensemble, certains fabricants de matériaux ferromagnétiques donnent une valeur propre au matériau. Par exemple, pour certains matériaux nanocristallins, on trouve des valeurs de l'ordre de 90000 pour la partie réelle et de l'ordre de 20000 pour la partie imaginaire de la perméabilité magnétique relative.

En pratique des essais en interne ont montré qu'avec une partie imaginaire de perméabilité magnétique supérieure à 10, des résultats intéressants sont déjà obtenus.

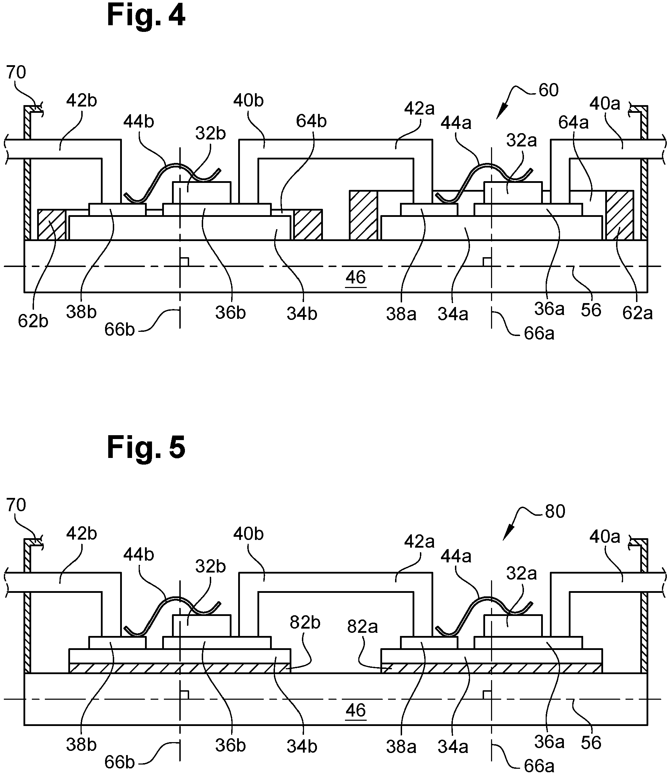

A l'aide de la figure 2, on s'est intéressé à la ou aux capacités parasites formées par le composant élémentaire 32 et sa partie de métallisation 36. Il est également possible d'entourer individuellement d'autres parties de métallisation et notamment la partie 38 qui peut former une capacité parasite avec la semelle 46. La figure 4 représente un autre exemple de composant de commutation 60 dans lequel on retrouve deux composants élémentaires 32a et 32b, chacun sur leur substrat, respectivement 34a et 34b, pour chacun des composants élémentaires, les deux parties de métallisation 36a, 38a et 36b, 38b, les deux broches 40a, 42a et 40b, 42b, les jambes 44a et 44b, ainsi que la semelle 46 commune aux deux composants élémentaires 32a et 32b. Dans cet exemple, les composants élémentaires sont par exemple de nature différente, par exemple un transistor pour le composant élémentaire 32a et une diode pour le composant élémentaire 32b. Les broches 42a et 40b sont communes. Il est également possible de les laisser séparées. D'autres broches, non représentées, peuvent également être présentes dans le composant 60, par exemple lorsque l'un des composants élémentaires est à commutation forcée ou pour relier une diode de roue libre à u transistor comme visible sur la figure 1. Le composant de commutation 60 comprend en outre un noyau magnétique 62a qui, à la différence du noyau 50, entoure le substrat 34a et un noyau magnétique 62b qui entoure le substrat 34b. Ainsi toutes les parties de métallisation s'étendant sur le substrat 34a et pouvant former de capacités parasites avec la semelle 46 sont entourées par le noyau magnétique 62a. De même, les parties de métallisation s'étendant sur le substrat 34b sont entourées par le noyau magnétique 62b. Les noyaux magnétiques 62a et 62b et leur évidement central, respectivement 64a et 64b s'étendant selon un axe respectif 66a et 66b possèdent toutes les caractéristiques énoncées plus haut pour le noyau magnétique 50. Notamment, les noyaux magnétiques 62a et 62b sont disposés dans le composant 60 de façon à ce que le chemin suivi par le signal utile ne forme pas de spire autour de chacun des noyaux magnétiques 62a et 62b.

Classiquement, les composants de commutation du commerce possèdent une encapsulation 70 recouvrant les substrats 34a et 34b et tous les éléments qui y sont fixés au-dessus de la semelle 46 à savoir les parties de métallisation 36a, 36b, 38a et 38b, les composants élémentaires 32a et 32b, les broches 40a, 40b, 42a, 42b et les jambes 44a 44b. Hors de l'encapsulation, sont accessibles : la semelle 46, pour y fixer un radiateur et les extrémités des broches 40a et 42b pour raccorder le composant 60. L'encapsulation 70 a été représentée sur la figure 4. Une même encapsulation existe aussi pour le composant 30 de la figure 2.

Les noyaux magnétiques 62a et 62b sont indépendants l'un de l'autre. Ils ne possèdent aucune partie commune. En effet, si des parties communes existaient elles pourraient se perturber l'une l'autre, notamment en cas de saturation d'un des noyaux. En complément, le fait de conserver les noyaux magnétiques 62a et 62b indépendants permet de choisir leur caractéristiques indépendamment l'un de l'autre. Il est notamment possible de choisir des matériaux différents pour les deux noyaux magnétiques 62a et 62b. Il est possible de mettre en œuvre un noyau magnétique sans entrefer et un noyau magnétique avec entrefer. Si l'un des composants élémentaires 32a et 32b n'est pas ou très peu sensible au courants de fuite, il est possible de ne mettre en œuvre qu'un seul noyau magnétique n'entourant que le composant élémentaire le plus sensible aux courants de fuite. Le noyau magnétique entourant ce composant élémentaire est alors parfaitement adapté à ce composant. En l'entourant au plus près, sans entourer l'autre composant, sa longueur magnétique est la plus courte possible et son efficacité d'autant meilleure.

Sur la figure 1, la charge 18 fonctionne en courant alternatif triphasé. L'onduleur 14 est formé de trois branches 14u, 14v et 14w permettant chacune de générer une des phases alternatives à partir de la tension continue délivrée par le redresseur 12. Chacune des branches comprend deux transistors T, par exemple de type IGBT, chacun associé à une diode D appelée diode de roue libre. Il est possible de réaliser dans une même encapsulation un composant de commutation formant une branche de l'onduleur. Plus précisément, à l'intérieur de l'encapsulation, le composant comprend deux transistors T et deux diodes D portées par un même substrat ou par des substrats distincts mais tous portés par une même semelle. Les transistors T et les diodes D sont raccordés à l'intérieur de l'encapsulation par la métallisation portée par le substrat s'il est unique. Les composants élémentaires formant chacune des diodes et chacun des transistors peuvent être entourés chacun par un noyau magnétique fermé ou ouvert.

La figure 5 représente une variante de réalisation de l'invention dans laquelle dans un composant 80, on retrouve différentes éléments du composant 60, à savoir les composants élémentaires 32a et 32b chacun monté sur leur substrat respectif 34a et 34b, les parties de métallisation 36a, 38a, 36b et 38b, les broches 40a, 42a, 40b, 42b, les jambes 44a et 44b, ainsi que la semelle 46 commune aux deux composants élémentaires 32a et 32b.

A la différence du composant 60, le composant 80 décrit sur la figure 5 permet d'illustrer un autre exemple de mise en place du noyau magnétique permettant de simplifier sa réalisation. Associé à chaque composant élémentaire 32a et 32b, un noyau magnétique, respectivement 82a et 82b, est ici en forme de plaque disposée entre le substrat, respectivement 34a, 34b, et la semelle 46 commune aux deux composants élémentaires 32a et 32b. La plaque est continue sans évidement comme dans les précédentes réalisations. En variante, il est également possible de disposer le noyau magnétique en forme de plaque sous la semelle 46 et plus précisément, entre la semelle 46 et un radiateur sur lequel la semelle est destinée à être fixée. Dans cette variante, pour le composant 80, deux noyaux magnétiques 82a et 82b sont disposés chacun en regard d'un composant élémentaire. Le courant de déplacement $I_D$ évoqué plus haut, traverse le noyau magnétique respectif 82a, 82b sensiblement perpendiculairement au plan dans lequel la plaque respective s'étend principalement. Le courant de déplacement $I_D$ induit une induction magnétique tournant dans le plan de la plaque à l'intérieur du noyau magnétique respectif 82a, 82b et dans la partie de la plaque correspondant aux différents noyaux magnétiques à évidement central décrits plus haut. La partie centrale du noyau magnétique respectif 82a, 82b centrée sur le courant de déplacement $I_D$ tend également à s'opposer au courant de déplacement $I_D$.

Comme dans les exemples représentés sur les figures 2 et 4, dans le mode de réalisation représenté sur la figure 5, le chemin suivi par le signal électrique commuté $I_C$ dans le ou les composants élémentaires représentés ne forme pas avec le ou les noyaux magnétiques respectifs de spire tendant à générer un champ magnétique induit dans le noyau magnétique considéré.

**Revendications**

1. Composant de commutation configuré pour commuter un signal électrique ($I_C$), le composant de commutation (30 ; 60 ; 80) comprenant :

   - un substrat (34 ; 34a,34b) portant plusieurs composants élémentaires (32a, 32b) assurant chacun la commutation du signal électrique ($I_C$),
   - une semelle (46) sur laquelle est fixé le substrat (34 ; 34a,34b), la semelle (46) étant configurée pour évacuer de la chaleur émise lors de commutations du composant de commutation,
   - deux conducteurs électriques (40, 42 ; 40a, 42a ; 40b, 42b) connectés à chacun un des composants élémentaires (32a, 32b) et assurant respectivement l'entrée et la sortie du composant élémentaire (32a, 32b) concerné pour le signal ($I_C$) à commuter,
   - un noyau magnétique (50 ; 62a, 62b ; 82a, 82b) réalisé en matériau ferromagnétique, le noyau magnétique (50 ; 62a, 62b ; 82a, 82b) entourant le composant élémentaire concerné (32a, 32b) sans entourer d'autres des composants élémentaires (32a, 32b) et étant disposé dans le composant (30 ; 60 ; 80) de façon à ce qu'un courant de déplacement ($I_D$) entre le composant élémentaire (32a, 32b) entouré et la semelle (46) induise une induction magnétique dans le noyau magnétique (50 ; 62a, 62b ; 82a, 82b), et de façon à ce que le chemin suivi par un courant de conduction du signal électrique ($I_C$) commuté par le composant (30 ; 60 ; 80) ne forme pas de spire autour du noyau magnétique (50 ; 62a, 62b ; 82a, 82b).

2. Composant de commutation selon la revendication 1, dans lequel le noyau magnétique (50 ; 62a, 62b ; 82a, 82b) est réalisé en matériau ferromagnétique possédant une partie imaginaire de perméabilité magnétique relative supérieure à 10.

3. Composant de commutation selon l'une des revendications précédentes, dans lequel le noyau magnétique (50 ; 62a, 62b ; 82a, 82b) est réalisé en matériau ferromagnétique nanocristallin.

4. Composant de commutation selon l'une des revendications précédentes, dans lequel le noyau magnétique (50 ; 62a, 62b) comprend un évidement central (52 ; 64a, 64b) entourant le composant élémentaire (32a, 32b).

5. Composant de commutation selon la revendication 4, dans lequel le noyau magnétique (50 ; 62a, 62b) est fermé.

6. Composant de commutation selon la revendication 4, dans lequel le noyau magnétique (50 ; 62a, 62b) est ouvert.

7. Composant de commutation selon l'une quelconque des revendications 1 à 3, dans lequel le noyau magnétique (82a, 82b) est en forme de plaque disposée sous le substrat (34a, 34b).

# Fig. 1

# Fig. 2

# Fig. 3

# Fig. 4

# Fig. 5

# EP 4 145 505 A1

Europäisches
Patentamt

European
Patent Office

Office européen
des brevets

## RAPPORT DE RECHERCHE EUROPEENNE

Numéro de la demande

EP 22 19 2146

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2018/122746 A1 (NGO KHAI [US] ET AL) 3 mai 2018 (2018-05-03) | 1-5,7 | INV. H01L25/07 |
| Y | * alinéa [0011] – alinéa [0022]; figures 1, 2A, 2B * | 6 | H01F17/06 H01L23/64 H02M1/12 |
| A | BARBA A. ET AL: "Magnetic complex permeability (imaginary part) dependence on the microstructure of a Cu-doped Ni-Zn-polycrystalline sintered ferrite", CERAMICS INTERNATIONAL , vol. 46, no. 10 1 juillet 2020 (2020-07-01), pages 14558-14566, XP055909835, NL ISSN: 0272-8842, DOI: 10.1016/j.ceramint.2020.02.255 Extrait de l'Internet: URL:https://www.sciencedirect.com/science/article/pii/S0272884220305812/pdfft?md5=db633a12b5b7fb32cfb91703ee2f4e4d&pid=1-s2.0-S0272884220305812-main.pdf * page 14558 – page 14660 * | 2 | H02M1/00 H02M7/00 H02M7/06 H02M7/5387 ADD. H01L23/00 H01L23/36 H01L23/367 H01L23/552 H03H1/00 |
| Y | US 2017/012593 A1 (TANIMIZU TOMOKAZU [JP] ET AL) 12 janvier 2017 (2017-01-12) * alinéa [0042]; figure 2 * | 6 | |
| A | US 2016/155706 A1 (YONEYAMA REI [JP] ET AL) 2 juin 2016 (2016-06-02) * alinéa [0019] – alinéa [0033]; figures 1, 2 * | 1,7 | |

DOMAINES TECHNIQUES RECHERCHES (IPC)

H01L
H03H
H02M
H01F

Le présent rapport a été établi pour toutes les revendications

| Lieu de la recherche | Date d'achèvement de la recherche | Examinateur |
|---|---|---|
| Munich | 30 janvier 2023 | Hirsch, Alexander |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

13

## ANNEXE AU RAPPORT DE RECHERCHE EUROPEENNE
## RELATIF A LA DEMANDE DE BREVET EUROPEEN NO.

**EP 22 19 2146**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**30-01-2023**

| Document brevet cité au rapport de recherche | Date de publication | Membre(s) de la famille de brevet(s) | Date de publication |
|---|---|---|---|
| US 2018122746 A1 | 03-05-2018 | AUCUN | |
| US 2017012593 A1 | 12-01-2017 | CN 106134054 A | 16-11-2016 |
| | | EP 3116113 A1 | 11-01-2017 |
| | | JP 6379401 B2 | 29-08-2018 |
| | | JP 2016059198 A | 21-04-2016 |
| | | US 2017012593 A1 | 12-01-2017 |
| | | WO 2016039414 A1 | 17-03-2016 |
| US 2016155706 A1 | 02-06-2016 | CN 105655323 A | 08-06-2016 |
| | | DE 102015218887 A1 | 02-06-2016 |
| | | JP 6233285 B2 | 22-11-2017 |
| | | JP 2016103941 A | 02-06-2016 |
| | | US 2016155706 A1 | 02-06-2016 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2887519 A2

- CA 954031738